# EUROPEAN PATENT SPECIFICATION

(11) **EP 1 901 354 B1**
(45) Date of publication and mention of the grant of the patent: **24.08.2016**
(21) Application number: 07010947.5
(22) Date of filing: 04.06.2007
(51) Int. Cl.: H01L 29/423, H01L 29/739, H01L 29/06, H01L 29/775

(54) **A tunnel field-effect transistor with gated tunnel barrier**
Tunnel-Feldeffekttransistor mit gategesteuerter Tunnelbarriere.
Transistor à effet de champ de tunnel et barrière de tunnel commandée par la grille.

(30) Priority: 15.09.2006 US 845006 P; 27.11.2006 EP 06024507; 12.03.2007 US 906440 P
(43) Date of publication of application: 19.03.2008
(73) Proprietor: IMEC, 3001 Leuven (BE); Katholieke Universiteit Leuven (KUL), 3000 Leuven (BE)
(72) Inventor: Vandenberghe, William G., 3000 Leuven (BE); Verhulst, Anne S., 2234 Houtvenne (BE)
(74) Representative: Office Kirkpatrick

(56) References cited:
- WO-A-2006/034887
- WO-A-2006/073477
- WO-A-2006/087044
- WO-A2-2004/004927
- US-A- 4 288 806
- US-A1- 2005 199 950
- US-A1- 2006 113 612
- KOUWENHOVEN L P ET AL: "Excitation spectra of circular, few-electron quantum dots" SCIENCE, AMERICAN ASSOCIATION FOR THE ADVANCEMENT OF SCIENCE,, US, vol. 278, no. 5344, 5 December 1997 (1997-12-05), pages 1788-1792, XP002138815 ISSN: 0036-8075
- LEE C: "SINGLE-ELECTRON TUNNELLING TRANSISTOR IN SIGE/SI DOUBLE-BARRIER STRUCTURES" SEMICONDUCTOR SCIENCE AND TECHNOLOGY, IOP, BRISTOL, GB, vol. 13, no. 8A, August 1998 (1998-08), pages A115-A118, XP000768875 ISSN: 0268-1242
- ONO YUKINORI ET AL: "Manipulation and detection of single electrons for future information processing" JOURNAL OF APPLIED PHYSICS, AMERICAN INSTITUTE OF PHYSICS. NEW YORK, US, vol. 97, no. 3, 19 January 2005 (2005-01-19), pages 31101-31101, XP012070568 ISSN: 0021-8979

## Description

### FIELD OF THE INVENTION

The present invention is related to the field of semiconductor devices. More specifically it is related to tunnel Field Effect Transistors (TFET) wherein the tunneling effect is band-to-band tunneling.

The invention further relates to a method of fabricating a semiconductor device, more particularly to a method for fabrication of tunnel Field Effect Transistors (TFETs). More specifically said fabrication method relates to but is not limited to standard planar technology, double gate technology, finFET technology and nanotechnology, wherein the latter includes implementations with integrated nanowires.

### BACKGROUND OF THE INVENTION

Microelectronic devices are generally fabricated on semiconductor substrates as integrated circuits. A complementary metal-oxide-semiconductor (CMOS) field effect transistor (FET) is one of the core elements of such integrated circuits. Dimensions and operating voltages of CMOS transistors are continuously reduced, or scaled down, to obtain ever-higher performance and packaging density of the integrated circuits.

One of the problems due to the scaling down of CMOS transistors is that the power consumption keeps increasing. This is partly because leakage currents are increasing (e.g. due to short channel effects) and partly because it becomes difficult to decrease the supply voltage. The latter is mainly due to the fact that the subthreshold slope is limited to minimally about 60 mV/decade, such that switching the transistor from ON to OFF needs a certain voltage variation and therefore a minimum supply voltage.

Tunnel field-effect transistors (TFETs) are typically advertised as successors of metal-oxide semiconductor field-effect transistors (MOSFETs), because of their absence of short-channel effects and because of their resulting low off-currents. Another advantage of TFETs is that the subthreshold slope can be less than 60 mV/dec, the physical limit of conventional MOSFETs, such that potentially lower supply voltages can be used. However, TFETs typically suffer from low on-currents, a drawback related to the large resistance of the tunnel barrier. The low on-currents result in long gate delays (gate delay τ_{gate} = C_{gate} * V_{dd} / I_{ds}, with C_{gate} the gate capacitance, V_{dd} the supply voltage, and I_{ds} the on-current) and correspondingly slow switching speed. TFETs are also ambipolar, which means that they are turned on for both high positive and high negative gate voltages. This ambipolar behaviour can result in an unwanted increase of the off-current.

In US 2005/0274992, a method of fabricating an improved TFET using nanowires is disclosed. The method comprises forming in a nanotube (i.e. a nanowire without axial opening) an n-doped region and a p-doped region that are separated by an undoped channel region of the transistor. Electrical contacts are provided for the doped regions and a gate electrode that is formed upon a gate dielectric layer is deposited on the channel region of the transistor. The proposed structure still has the disadvantage of strong ambipolar behaviour.

To increase the on-current of a silicon TFET, suggestions have been made in literature by Bhuwalka et al. (IEEE transactions on electron devices Vol. 52, No 7, July 2005) to add a small (about 3 nm wide) section of highly-doped Siₗ₋ₓGeₓ at the tunnel barrier. The Siₗ-ₓGeₓ has a smaller band gap than Si such that the effective tunnel barrier width decreases due to the presence of this section. However, these structures with the Siₗ₋ₓGeₓ section can still not compete with conventional MOSFETs because of their low on-currents.

Appenzeller et al., in "Comparing Carbon Nanotube Transistors - The Ideal Choice: A Novel Tunneling Device Design" (IEEE Trans. Electron Devices, Vol. 52, pp 2568-2576 (2005)), describes a carbon nanotube based TFET, however this proposed structure still has the disadvantage of strong ambipolar behaviour.

Wang et al., in "Complementary tunneling transistor for low power application" (Solid-State Electronics Vol 48, pp 2281-2286 (2004)), describes the fabrication of complementary TFETs and illustrates the low power consumption of the complementary silicon TFETs. To reduce the ambipolar behaviour of the TFET, the pTFET (nTFET) has a lower p-type (n-type) doping level for the drain contact than the n-type (p-type) doping level for the source contact. This implementation has the disadvantage of an increased number of processing steps for fabrication of such devices due to the different doping levels for pTFET and nTFET. The on-current of the silicon TFETs is, furthermore, not yet comparable with the on-current of the MOSFET.

As a conclusion, there is still a need for an improved TFET design.

WO 2006/034887 relates to an EEPROM control circuit which comprises tunnel field effect transistors and is producible, in particular on a small chip surface.

"Excitation spectra of circular, few-electron quantum dots" L.P. Kouwenhoven, et al., discloses studies of the ground and excited states in semiconductor quantum dots and a unassociated device.

In "Single-electron tunneling transistor in SiGe/Si double-barrier structures" a single-electron transistor (SET) on a SiGe/Si double-barrier structure has been studied with side contacts.

In WO 2006/087044 A1, an integrated circuit arrangement is disclosed comprising a field effect transistor, especially a tunnel field effect transistor.

In US 4,288,806, integrated monolithic arrays of high voltage metal oxide semiconductor field effect transistors are disclosed having closed geometry grounded peripheries for interdevice isolation, which are able to function as drivers that may be switched on and off.

In US 2006/0113612, a method is disclosed which improves semiconductor device performance via an insulated-gate PIN-type structure that is adapted to abruptly switch between conductance states by modulating an electric field in the intermediate region.

### SUMMARY OF THE INVENTION

It is an object of the present invention to provide a good semiconductor device according to claim 1 and methods of making the same according to claim 15.

An advantage of the present invention is that the semiconductor device architecture can have a low power consumption. A Tunnel Field Effect Transistor (TFET) with a high switching speed and a method for the manufacturing of such semiconductor device structures are disclosed. In addition to the advantage of a high, (preferably an improved switching speed compared to prior art solutions), said novel TFET structure has a processing advantage, as well as a performance improvement. The processing advantage is achieved at least in part by the fact that no alignment of the gate with the drain is necessary. The performance improvement is due at least in part to the fact that the ambipolar behaviour of the TFET according to the present invention is reduced and/or avoided.

The novel TFET structure according to embodiments of the present invention differs from traditional TFET structures because in said novel TFET structure the gate does not align with or cover the drain, and only overlaps with the source and optionally with part of the channel. Alignment of gate and drain in the context of the present invention means that the gate and drain each touch a same plane, in particular the plane of the drain-channel interface. In embodiments of the present invention, the gate may optionally overlap with part of the channel. Due to the shorter gate, compared to prior art TFETs, the total gate capacitance is reduced, which is directly reflected in an improved switching speed of the device.

The invention discloses the creation of a tunnel field effect transistor having a good, in embodiments of the present invention even an improved switching speed, and/or a processing advantage (no alignment of the gate with the drain is necessary), and/or a performance improvement (the ambipolar behaviour of the TFET is reduced or, in embodiments of the present invention, even avoided).

The present invention solves the problem of gate delay and hence long switching times of traditional TFET devices by introducing a new gate design, more specifically a different gate-channel overlap. The proposed structure of embodiments of the invention is in fact a traditional TFET wherein the gate does not align with or cover the drain, and only overlaps with the source and, optionally, with part of the channel. In the present invention, due to the shorter gate, compared to prior art devices, the total gate capacitance is reduced, which is directly reflected in an improved switching speed of the device. The TFET structure of the present invention having a shorter gate compared to prior art devices will be further referred to with respect to the present invention as "short gate TFET".

The short gate TFET structure of embodiments of the present invention, having a shorter gate than prior art TFETs, solves problems of traditional TFET structures while still keeping the absence of short channel effects of a traditional TFET, and their resulting low off currents leading towards improved on-chip power consumption. Also the subthreshold slope can be kept lower than 60 mV/dec, the physical limit of a conventional MOSFET, such that potentially lower supply voltages can be used.

In an embodiment of the invention, the short gate TFET of the present invention can comprise a nanowire (NW) structure (further referred to as a NW-TFET), said nanowire structure forming the channel region, source/drain regions and optionally a heterosection. Said heterosection may be situated in between the channel region and one of the source or drain regions. The absence of gate-drain alignment or coverage in the short gate TFET according to the present invention may be especially attractive in the fabrication of a NW-TFET because it is leading to a more realistic processing. Whilst in planar technology, alignment of the gate with the source and drain is achieved through self-alignment of the source and drain implantations, it is not yet clear in prior art how a good alignment of the drain and source doping with the gate can be achieved in a vertical structure such as a NW-TFET. The short gate TFET according to embodiments of the present invention does not require alignment of the gate with the drain, which reduces processing constraints.

Embodiments of the invention relate to micro- and nanoelectronics and may optionally be used for developing low power semiconductor device structures.

In a particular embodiment of the invention, a nanowire Tunnel Field Effect Transistor semiconductor device according to claim 1 is disclosed.

In alternative embodiments of the present invention, the gate electrode is only covering at least part of the at least one source region, said coverage extending up to the plane of the interface of the source-channel region. In this embodiment, the gate electrode does not or does not substantially cover the channel.

The short gate TFET of embodiments of the present invention may further comprise a gate dielectric underneath the gate electrode, i.e. in between the source-channel-drain structure and the gate electrode, said gate dielectric covering at least part of the at least one source region extending up to the plane of the source-channel region. The gate dielectric may optionally cover part of the source, channel and/or drain regions which are not covered by the gate electrode. The gate dielectric, for example gate oxide, may be selected from at least one of silicon based oxides (e.g. silicon dioxide, silicon oxy nitride), aluminium oxide, high-k oxides (e.g. oxides, nitrided oxides, silicates and nitrided silicates of transition metals such as Hf, Ta, Ti, Nb, V, Y, Zr). In particular embodiments, the gate oxide is a high-k oxide such as hafnium oxide. The thickness of the gate dielectric, e.g. gate oxide, is preferably in the range of 0.5 nm to 20 nm. The gate electrode may be provided upon said gate dielectric such that it is not extending beyond said gate dielectric.

In embodiments of the present invention, the gate electrode material may be made of a conductive material. The gate electrode material may be selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE). The gate electrode material may be chosen such that a particular gate workfunction is obtained.

The at least one source region in the short gate TFET of embodiments of the present invention may be made of a semiconductor material which is highly p doped (or n doped).

The at least one drain region in the short gate TFET of embodiments of the present invention may be made of a semiconductor material which is highly n doped (or p doped).

The doping level of the source region and drain region in the short gate TFET of some embodiments of the present invention may be in the range of 10¹⁸/cc to 10²¹/cc, for example the doping level of the source region and drain region may be in the range of 10¹⁹/cc to 5x10²⁰/cc.

The at least one channel region in the short gate TFET of embodiments of the present invention may be made of a semiconductor material which is lowly n doped (or p doped) and which is situated in between the source and drain region.

The doping level of the channel region in the short gate TFET according to the present invention is in the range of undoped up to 10¹⁶/cc, for example the doping level of the channel region may be in the range of undoped up to 5x10¹⁴/*cc*.

The length L_{channel} of the channel region in the short gate TFET of some embodiments of the present invention may be in the range of 5 nm to 50 µm, for example in the range of 10 nm to 5 µm.

The length of the gate electrode in a NW short gate TFET according to embodiments of the present invention, or in other words the length of the short gate (referred to as L_{gate}) may be between 1 nm and 50 µm, for example between 5nm and 5 µm.

According to embodiments of the present invention, the length of the channel region which is not covered by a gate electrode (referred to as Lₙₒ overlap) may be in the range of 1 nm up to the whole length of the channel region (no overlap wherein the gate electrode only covers the source region), for example in the range of 5 nm up to the whole length of the channel region.

In the short gate TFET of embodiments of the present invention, the overall semiconductor material, i.e. the basic material from which the source, channel and drain are formed may be selected from at least one of group IV materials such as Si, Ge, C and binary compounds thereof, or group III/V materials such as In, Ga, As, Sb, Al, P, B, N and binary, tertiary and quaternary compounds thereof or group II/VI materials such as Cd, Zn, S, Se, Te, O and binary, tertiary and quaternary compounds thereof, or carbon nanotubes.

According to a particular embodiment, the short gate TFET of the present invention may be a NW-TFET which further comprises a heterosection. Said heterosection may be made of a semiconductor material (referred to as heterosection material) which is different from the overall semiconductor material of the short gate TFET. Said heterosection may be highly doped and may be situated in between the source region (or drain region) and the channel region. Alternatively, said heterosection can be made of a metal such as Al, W, Ta, Ti, Ru, Pd, Rh, Re, Pt, or alloys thereof, a silicide, a germanide, a metal-nitride such as TaN and TiN, a conductive oxide such as RuO₂ and ReO₂, a silicided metal such as CoSi₂, NiSi₂ ,a metal germanide and/or alloys and mixtures thereof. The heterosection (semiconductor) material in the short gate NW-TFET of embodiments of the present invention may have interfaces with reduced number of defects, e.g. defect free interfaces (such as e.g. avoiding dislocations during growth), to the overall semiconductor material. It may be made of a material that has a lattice constant which is different from the lattice constant of the overall semiconductor material of the short gate TFET. Said heterosection semiconductor material may be selected from at least one of group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof. The heterosection semiconductor material may be germanium or Siₗ₋ₓGeₓ with x>0.5. The short gate of the short gate NW-TFET may be covering at least part of the at least one source region of the source-channel-drain structure along its longitudinal direction, extending at least up to the plane of the source-channel interface, and, optionally, part of the at least one channel region such that there is a finite distance between the end of the gate electrode oriented towards the channel and the plane of the channel-drain interface such that there is no coverage of the drain region by the gate electrode (referred to as short gate). Alternatively, the gate electrode may be only covering at least part of the at least one source region, said coverage extending up to the plane of the source-channel interface.

The short gate TFET of some embodiments of the present invention may further comprise an electrical contact to each of the source regions and drain regions. The electrical contact on each of the source regions and drain regions may be a conductive material which may be selected from at least one of a silicide containing structure (NiSi, CoSi₂, TiSi₂, ...), a germanide containing structure, a metal containing structure, poly silicon or a combination thereof. Said electrical contact on each of the source regions and drain regions may be a combination of a metal with a silicide.

According to another embodiment of the invention the source-channel-drain structure may be a horizontal structure and said gate electrode (short gate) may be a double gate structure situated on the sidewalls of said horizontal source-channel-drain structure.

According to another embodiment of the invention the said short gate TFET may be a triple-gate FET (e.g. FinFET). In these embodiments, said gate electrode may be a triple gate structure situated on the sidewalls and on top of the source-channel-drain structure of the triple-gate FET.

According to yet another embodiment of the invention said source-channel-drain structure may be a horizontal or vertical structure. In these embodiments, said gate electrode (short gate) may be an all-around gate structure around said horizontal or vertical source-channel-drain structure.

According to the invention, the short gate TFET comprises a NW. The diameter of the NW, perpendicular to its longitudinal axis, may be in the range of 1 nm up to 500 nm, for example the diameter of the NW may be between 2 and 200 nm. The length of the NW, along its longitudinal axis used may be in the range of 5 nm and 50 µm, for example the length of the NW used in the short gate TFET of the present invention may be between 10 nm and 5 µm.

According to embodiments of the invention, the short gate TFET may be a NW-TFET which comprises a heterosection. The length of the heterosection may be in the range of 1 nm and 50 nm, for example the length of the heterosection may be between 2 nm and 10 nm. The doping level of the heterosection in the short gate TFET of the present invention may be in the range of 10¹⁸/cc to 10²¹/cc, for example the doping level of the heterosection may be in the range of 10¹⁹/cc to 5x10²⁰/cc.

According to a particular embodiment of the invention, the short gate TFET of the present invention may further comprise a second gate on the remainder of the channel. This second gate may cover part of the channel region. The electrical equivalent circuit thereof is a TFET in series with a MOSFET. Said second gate structure can be a single gate structure, a double gate structure, a triple gate structure or an all-around gate structure depending on the type of TFET (planar, FinFET, NW-TFET,...) as described above in embodiments of the invention.

Furthermore a method for manufacturing a nanowire TFET semiconductor device, called short gate TFET, according to claim 15 is disclosed.

According to embodiments of the present invention, source and drain contacts may be provided. Furthermore, the source, drain and/or channel regions may be doped with a desired dopant type to a desired doping level.

Furthermore a method for manufacturing a short gate NW-TFET semiconductor device is disclosed. Said method comprises the steps of :
- providing on a substrate at least one drain contact onto which optionally a catalyst is deposited,
- growing a nanowire structure made of a semiconductor material, said nanowire having an integrated drain region, a channel region, and a source region, there being a source-channel interface and a drain-channel interface,
- optionally doping (selectively) said source region, channel region and drain region to a desired doping level and dopant type,
- depositing at least partly on the side walls of the nanowire a gate dielectric (e.g. oxide),
- depositing on top of the gate dielectric (e.g. oxide) a gate electrode, said gate electrode being situated on said gate dielectric so as to not extend beyond said gate dielectric, the gate electrode covering at least part of the at least one source region of the source-channel-drain structure along the longitudinal direction thereof and extending at least up to the plane of the source-channel interface, and, optionally, part of the at least one channel region, such that there is a finite distance between the end of the gate electrode oriented towards the channel and the plane of the channel-drain interface such that there is no coverage by the gate electrode (referred to as short gate) of the drain region,
- forming a source contact on top of the source region of the nanowire.

For the application in tunnel field-effect-transistor devices the nanowire in a short gate NW-TFET may form the channel and potentially also the source and drain regions of the tunnel field-effect transistor. Alternatively, either the source or drain regions of the tunnel field-effect transistor are situated in the substrate whereby said substrate comprises highly doped regions acting as source and drain regions.

Furthermore a method for manufacturing a short gate NW-TFET semiconductor device comprising a heterosection is disclosed whereby said method comprises the steps of :
- providing on a substrate at least one drain contact, onto which optionally a catalyst is deposited
- growing a nanowire structure, said nanowire having an integrated drain region, a channel region and a source region whereby said source region, channel region and drain region are made of a semiconductor material and the channel region further comprises an integrated heterosection which is made of a different (heterosection) semiconducting material having a different lattice constant, there being a source-channel interface and a drain-channel interface,
- selectively doping said source region, channel region, heterosection and drain region to the desired doping level and dopant type.
- depositing at least partly on the side walls of the nanowire a gate dielectric (e.g. oxide)
- depositing on top of the gate dielectric (oxide) a gate electrode, said gate electrode being situated on said gate dielectric so as to not extend beyond said gate dielectric, the gate electrode covering at least part of the at least one source region of the source-channel-drain structure along the longitudinal direction thereof and part of the at least one channel region such that there is a finite distance between the end of the gate electrode coverage towards the channel and the plane of the channel-drain interface such that there is no coverage by the gate electrode (referred to as short gate) of the drain region.
- forming a source contact on top of the source region of the nanowire.

In a particular embodiment, the substrate used for manufacturing a NW-TFET may be a Si wafer.

In a particular embodiment the length of the channel region (referred to as L_{channel}) is in the range of 5 nm to 50 µm, for example in the range of 10 nm to 5 µm.

In a particular embodiment the length of the gate electrode in the (NW) short gate TFET, or in other words the length of the short gate (referred to as L_{gate}) is between 1 nm and 50 µm, e.g. between 5nm and 5 µm.

In a particular embodiment the length of the channel region which is not covered by a gate electrode (referred to as Lₙₒ overlap) is in the range of 1nm up to the whole length of the channel region (no overlap wherein the gate electrode only covers the source region), for example Lₙₒ overlap may be in the range of 5 nm up to the whole length of the channel region.

In a particular embodiment the doping level of the source region and drain region is in the range of 10¹⁸/cc to 10²¹/cc, for example the doping level of the source region and drain region may be in the range of 10¹⁹/cc to 5x10²⁰/cc.

According to the invention the doping level of the channel region is in the range of undoped up to 10¹⁶/cc doping, for example the doping level of the channel region may be in the range of undoped up to 5x10¹⁴/cc doping.

In a particular embodiment, the (overall) semiconductor material is selected from at least one of group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof, or carbon nanotubes.

In a particular embodiment, said heterosection is made of a different semiconductor material (different compared to the overall semiconducting material), whereby said heterosection semiconductor material is such that it has a different lattice constant than the overall semiconductor material (e.g. of the nanowire).

In a particular embodiment, said heterosection semiconductor material may be selected from at least one of the group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof. In particular embodiments said heterosection semiconductor material may be germanium or Siₗ₋ₓGeₓ with x>0.5.

Alternatively, said heterosection can be made of metals (Al, W, Ta, Ti, Ru, Pd, Rh, Re, Pt, or alloys thereof), silicides, germanides, metal-nitrides such as TaN and TiN, conductive oxides such as RuO₂ and ReO₂, silicided metals such as CoSi₂, NiSi₂, metal germanides or alloys or mixtures thereof.

In a particular embodiment the length of the heterosection in the short gate NW-TFET device comprising a heterosection is in the range of 1 nm up to 50 nm, for example the length of said heterosection may be in the range of 2 nm to 10 nm.

In a particular embodiment the doping level of the heterosection is in the range of 10¹⁸/cc to 10²¹/cc, for example the doping level of the heterosection may be in the range of 10¹⁹/cc to 5x10²⁰/cc.

In a particular embodiment the diameter of the nanowire in the NW short gate TFET is between 1 and 500 nm, for example the diameter of the nanowire may be between 2 and 200 nm. The length of the nanowire in the NW short gate TFET may be between 5 nm and 50 µm, for example the length of the nanowire may be between 10 nm and 5 µm.

In a particular embodiment the gate dielectric may be an oxide, for example an oxide selected from at least one of silicon based oxides (e.g. silicon dioxide, silicon oxy nitride), aluminium oxide, high-k oxides (oxides, nitrided oxides, silicates and nitrided silicates of transition metals such as Hf, Ta, Ti, Nb, V, Y, Zr). In particular embodiments, the gate oxide may be a high-k oxide such as hafnium oxide.

In a particular embodiment the gate electrode may be made of a conductive material. Such conductive material may be selected from at least one of poly silicon, poly germanium, metals such as Al, W, Ta, Ti, Ru, Pd, Rh, Re, Pt, or alloys thereof, metal-nitrides such as TaN and TiN, metal-silicon nitrides such as TaSiN, conductive oxides such as RuO₂ or ReO₃, fully silicided metals (FUSI) such as CoSi₂, NiSi and TiSi₂, fully germanided metals (FUGE), workfunction tunable metals, engineered materials to obtain a particular gate workfunction.

In a particular embodiment the gate electrode may be made of a metal of which the workfunction has been engineered specifically for the chosen channel material and doping.

In a particular embodiment the source and drain contact may be made of a conductive material which is selected from at least one of a silicide containing structure (NiSi, CoSi₂, TiSi₂, ...), a germanide containing structure, a metal containing structure, poly silicon or a combination thereof. The source and drain may be a combination of a metal with a silicide.

The concept of the short gate TFET of embodiments of the present invention and other characteristics, features and advantages of the present invention are applicable to all types of TFET implementations, including but not limited to planar TFETs, double-gate TFETs, tri-gate TFETs (like FinFETs), and all-around TFETs, including but not limited to all horizontal and all vertical TFET implementations, including both implementations with a bulk contact and without a bulk contact.

The concept of the short gate TFET of embodiments of the present invention and other characteristics, features and advantages of the present invention are furthermore applicable to all TFETs independent of the channel doping, including both p-type channel doping, n-type channel doping and intrinsic doping.

The concept of the short gate TFET of embodiments of the present invention and other characteristics, features and advantages of the present invention are furthermore applicable to all TFET implementations, independent of the semiconductor material used as source material, as channel material, and as drain material, including TFETs with a source material which is different from the channel material and/or which is different from the drain material, including TFETs with a drain material which is different from the channel material. Possible semiconducting materials are including but not limited to group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof, or carbon nanotubes.

The concept of the short gate TFET of embodiments of the present invention and other characteristics, features and advantages of the present invention are furthermore applicable to all TFET implementations, independent of the gate dielectric material and thickness. Possible gate dielectric materials are including but not limited to silicon based oxides (e.g. silicon dioxide, silicon oxy nitride), aluminium oxide, high-k oxides (oxides, nitrided oxides, silicates and nitrided silicates of transition metals such as Hf, Ta, Ti, Nb, V, Y, Zr).

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### BRIEF DESCRIPTION OF THE DRAWINGS

Exemplary embodiments are illustrated in referenced figures of the drawings. It is intended that the embodiments and figures disclosed herein are to be considered illustrative rather than restrictive.
Figure 1 (PRIOR ART) shows a cross section of a traditional TFET structure whereby the gate overlaps with the whole of the channel region, including a small overlap with both the source and drain regions of the TFET structure;
Figure 2A illustrates a cross-section of the TFET structure according to an embodiment of the invention whereby the gate does not align with or cover the drain, and only overlaps with part of the source and part of the channel. Figure 2B illustrates the fact that the TFET structure according to embodiments of the present invention (as shown in Figure 2A) can be approximated by a pn tunnel diode which is coupled in series with a n-i-n resistor;
Figure 3 (PRIOR ART) illustrates a more detailed cross section of a traditional TFET structure whereby the gate overlaps the whole channel region including a small overlap with both the source and drain regions of the TFET structure;
Figure 4 illustrates a more detailed cross section of the TFET structure according to an embodiment of the invention whereby the gate does not align with or cover the drain, and only overlaps with part of the source and, in the embodiment illustrated, with part of the channel;
Figure 5 illustrates simulated output characteristics for an all silicon TFET with a 100nm and 1000nm channel having a full gate or partial gate according to embodiments of the present invention (gate length = 30nm) after applying a drain voltage, V_{DS} = 1 V. The Figure illustrates the drain current I_{Ds} as a function of gate voltage V_{GS} (varied from -0.5V up to 1V);
Figure 6 illustrates simulated output characteristics for an all germanium TFET with a 100nm channel having a full gate or partial gate according to embodiments of the present invention (gate length = 95nm having 5nm gate-source overlap) after applying a drain voltage, V_{DS} = 1 V. The Figure illustrates the drain current I_{Ds} as a function of gate voltage V_{GS} (varied from -0.5V up to 1V);
Figure 7 illustrates an alternative cross section of the TFET structure of embodiments of the present invention having two channel regions and two drain sections and whereby the gate only overlaps with the source section and not with the channel region;
Figure 8A illustrates a cross section of a double gate TFET structure according to embodiments of the present invention versus a cross section of a single gate TFET structure (Figure 8B) according to embodiments of the present invention (according to planar technology);
Figure 9A illustrates a cross section of a (double) short gate TFET structure (acting as an n-TFET) according to an embodiment of the present invention, having a second (short) gate structure on the remainder of the channel which covers only part of the channel region. Figure 9B illustrates the complementary structure (acting as a p-TFET) of Figure 9A, according to an embodiment of the present invention;
Figure 10A illustrates a cross-section of a NW-TFET structure, Figure 10B illustrates a cross section of a short gate NW-TFET according to an embodiment of the invention;
Figure 11 illustrates a flowchart of a processing method according to embodiments of the present invention to fabricate a short gate TFET ;
Figure 12 illustrates a flowchart of a processing method according to embodiments of the present invention to fabricate a short gate NW-TFET.

### DETAILED DESCRIPTION OF ILLUSTRATIVE EMBODIMENTS

Embodiments of the present invention will be described with respect to particular embodiments and with reference to certain drawings but the invention is not limited thereto but only by the claims. The drawings described are only schematic and are non-limiting. In the drawings, the size of some of the elements may be exaggerated and not drawn to scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

Whenever reference is made hereinafter to a particular dopant type, this is done for the ease of explanation only and is not intended to limit the invention. It is to be understood that in the examples given herein below, materials and dopant types may be replaced by other suitable materials and dopant types, without changing the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising components A and B" should not be limited to devices consisting only of components A and B. It means that with respect to the present invention, the only relevant components of the device are A and B.

It is further to be noticed that the term "short gate" refers to the gate electrode and not implicitly to the whole gate structure comprising the gate electrode and gate dielectric. In embodiments of the present invention, the gate dielectric is situated at least underneath the whole gate electrode but can furthermore cover the whole channel and optional source and drain region without altering (changing) the objectives of the invention.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

At least some embodiments of the present invention are concerned with the problem of too low ON currents and ambipolar behaviour in existing tunnel field effect transistors (TFET). Embodiments of the invention propose a different gate design such that the TFET has a much reduced (or even no) ambipolar behaviour (leading towards reduced off-currents and therefore reduced power consumption) and a reduced capacity (leading towards higher switching rates). More specifically, according to embodiments of the present invention a new gate electrode design is disclosed whereby the gate does not overlap with the drain region of the TFET, said new TFET design having a shorter gate electrode structure than prior art designs, which new structure is referred to as short gate TFET. Furthermore a heterosection can be (optionally) introduced in the channel region of the short gate TFET. Said heterosection is then situated in between the channel region and the source (or drain) region of the TFET and will increase the on current of the TFET.

In a first aspect of the invention, a novel TFET device is disclosed having a new gate electrode design, more specifically a novel gate (electrode) design whereby the gate does not align with or cover the drain, and only overlaps with the source and, optionally, part of the channel. Said novel TFET is further described below according to embodiments of the invention and referred to in general as a short gate TFET.

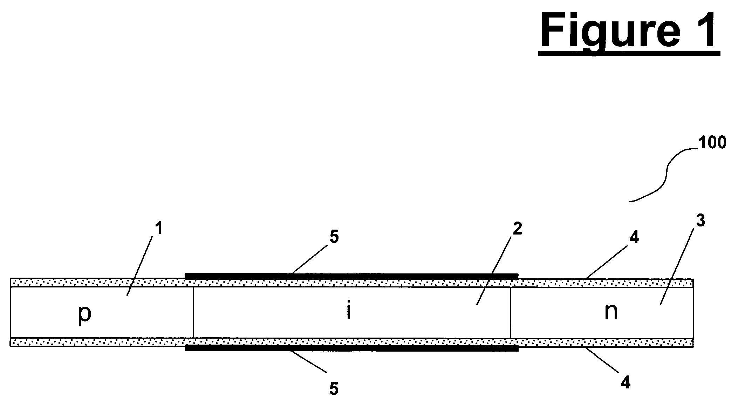

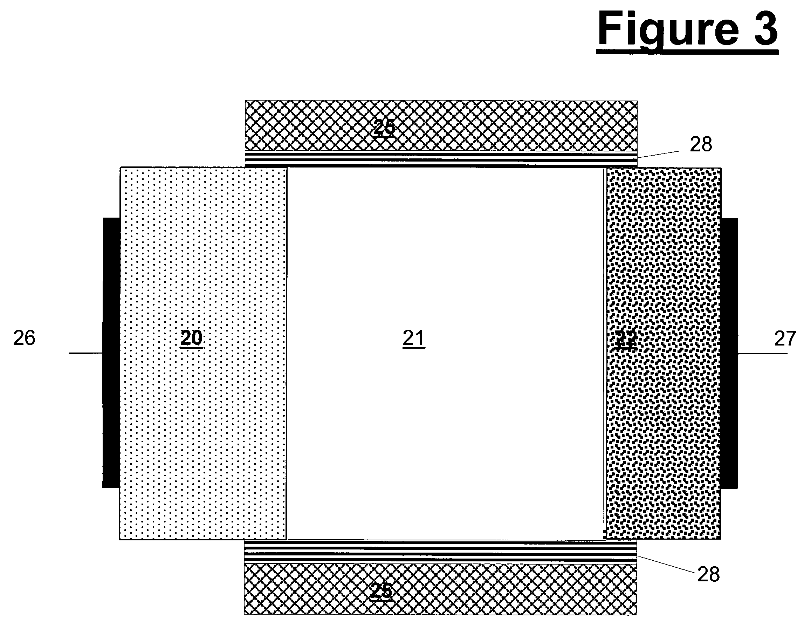

Figure 1 illustrates a cross section of a traditional TFET structure **100** whereby the gate 5 overlaps with the whole channel region **2** including a small overlap with both the source 1 and drain **3** regions of the TFET structure. The TFET structure as illustrated in Figure 1 further comprises a gate dielectric **4,** at least between the source-channel-drain structure and the gate electrode 5. Figure 3 illustrates a more detailed cross section of a traditional TFET structure whereby the gate structure (comprising a gate electrode **25** and gate dielectric **28)** overlaps with the whole channel region **21** including a small overlap with both the source **20** and drain **22** regions of the TFET structure. The TFET structure as illustrated in Figure 3 further comprises a source contact **26,** a drain contact **27** and a gate dielectric **28** underneath the gate electrode **25.**

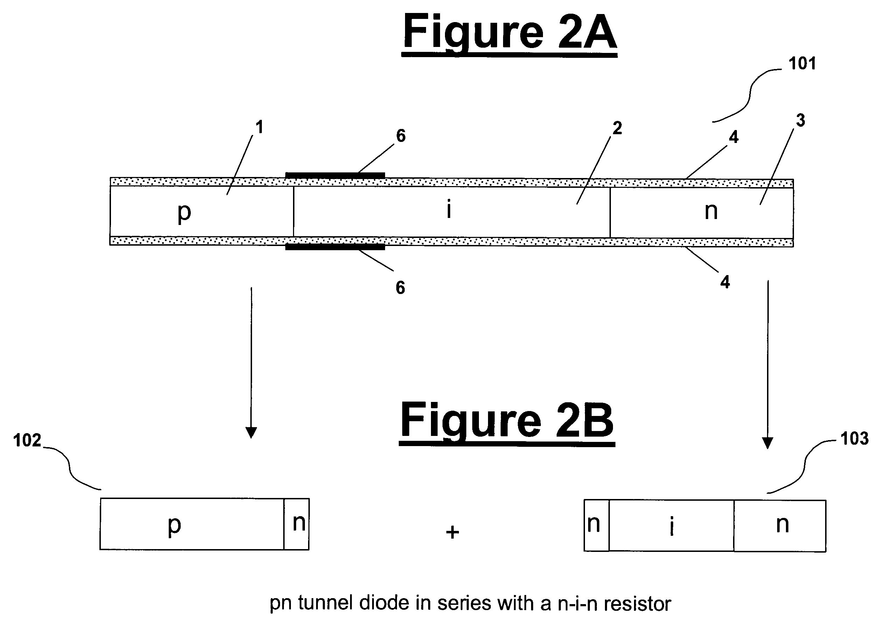

Figure 2A illustrates a cross-section of the short gate TFET structure **101** according to an embodiment of the invention whereby at least the gate electrode **6** does not align or overlap with the drain **3,** and only overlaps with the source **1** and, in the embodiment illustrated, with part of the channel **2.** The short gate TFET structure **101** as illustrated in Figure 2A further comprises a gate dielectric **4.** Figure 2B illustrates the fact that the short gate TFET structure according to embodiments of the present invention (for example the embodiment as shown in Figure 2A) can be approximated by a pn tunnel diode 102 which is coupled in series with a n-i-n resistor **103.**

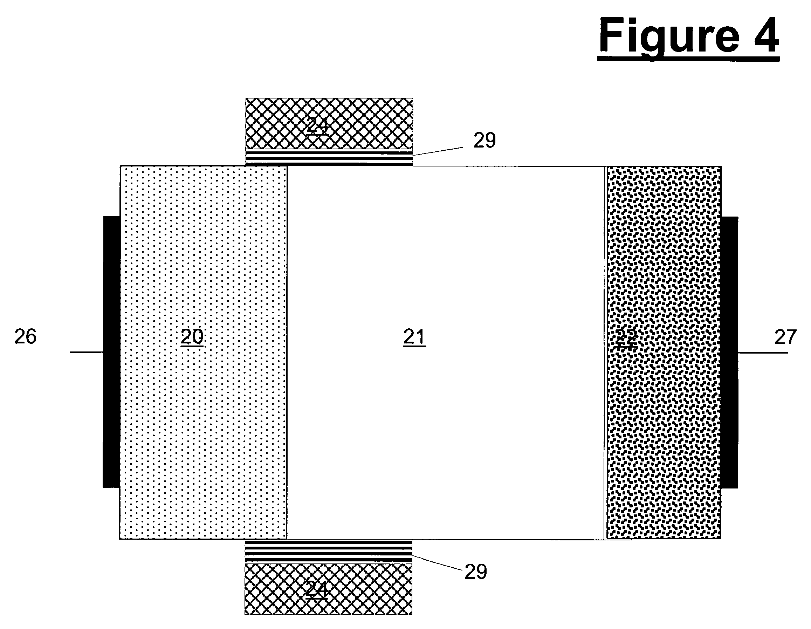

Figure 4 illustrates a more detailed cross section of the short gate TFET structure according to an embodiment of the invention whereby the gate does not align or overlap with the drain, and only overlaps with the source and, in the embodiment illustrated, with part of the channel. Said short gate TFET comprises at least one doped source region **20,** at least one doped drain region **22,** and at least one channel region **21** which is situated in between the source **20** and drain **22** region, thus forming a source-channel interface and a drain-channel interface. The short gate TFET furthermore comprises a gate electrode **24** covering at least part of the at least one source **20** region and at least extending up to the plane of the source-channel region, and optionally covering part of the at least one channel **21** region such that there is a finite distance between the end of the gate electrode **24** coverage of the channel and the plane of the channel-drain interface, such that there is no coverage by the gate electrode **24** (short gate) of the drain region **22.** The short gate TFET structure as illustrated in Figure 4 further comprises a gate dielectric **29** underneath the gate electrode **24** (short gate). Said gate dielectric is at least situated along the whole length of the gate electrode but can cover the whole length of the TFET structure. The short gate TFET structure in Figure **4** further comprises a source contact **26** and drain contact **27.**

The short gate TFET of embodiments of the present invention can comprise a nanowire (NW) structure (further referred to as a NW-TFET), said nanowire at least comprising the channel region, either one or both of source and drain regions and optionally a heterosection.

The short gate TFET of embodiments of the present invention is applicable to all TFET implementations, including but not limited to a planar TFET, a double-gate TFETs, a tri-gate TFET (like FINFET), and an all-around TFET, including but not limited to all horizontal and all vertical TFET implementations, including both implementations with a bulk contact and without a bulk contact. Said bulk contact can be defined as a highly doped region situated in the substrate

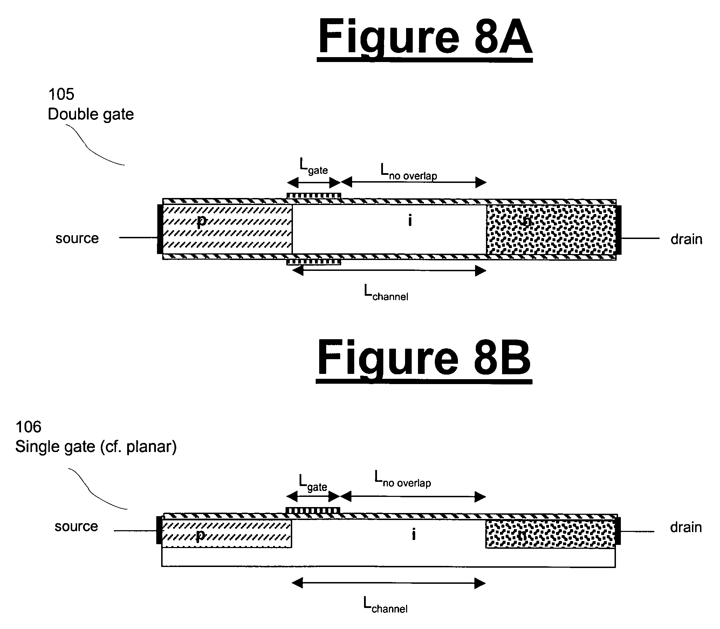

According to an embodiment of the invention, the short gate TFET can be a single gate TFET structure **106** (Figure 8B) referring to a planar TFET structure whereby the source, channel and drain regions are situated in a substrate and whereby the (short) gate is situated at least partly on top of the source region, extending up to the plane of the interface of the source-channel region and, optionally and as illustrated in Fig. 8B, further extending on top of the channel region but not extending on the drain region. An example of such a short gate TFET having a single (short) gate is illustrated in Figure 8B.

Alternatively, the short gate TFET of embodiments of the invention can be a double gate TFET structure **105** (Figure 8A). The (short) gate is situated at least partly on the sidewalls of the source region, extending up to the plane of the interface of the source-channel region and, optionally and as illustrated in Fig. 8A, further extending on the sidewalls of the channel region but not extending on the sidewalls of the drain region. An example of such a short gate TFET having a double (short) gate is illustrated in Figure 8A.

Both Figures 8A and 8B illustrate clearly that the short gate electrode (indicated as L_{gate}) in accordance with embodiments of the present invention covers at most part of the whole channel length (indicated as L_{channel}), such that there is still a part of the channel left which is not covered by the short gate (electrode) structure (indicated as Lₙₒ overlap). The length of the channel region (L_{channel}) may for example be in the range of 5 nm to 50 µm, for example in the range of 10 nm to 5 µm. The length of the gate electrode in the short gate TFET (L_{gate}) may for example be between 1 nm and 50 µm, e.g. between 5nm and 5 µm. The length of the channel region which is not covered by a gate electrode (L_{no overlap}) may for example be in the range of 1nm up to the whole length of the channel region (no overlap wherein the gate electrode only covers the source region), such as e.g. in the range of 5 nm up to the whole length of the channel region.

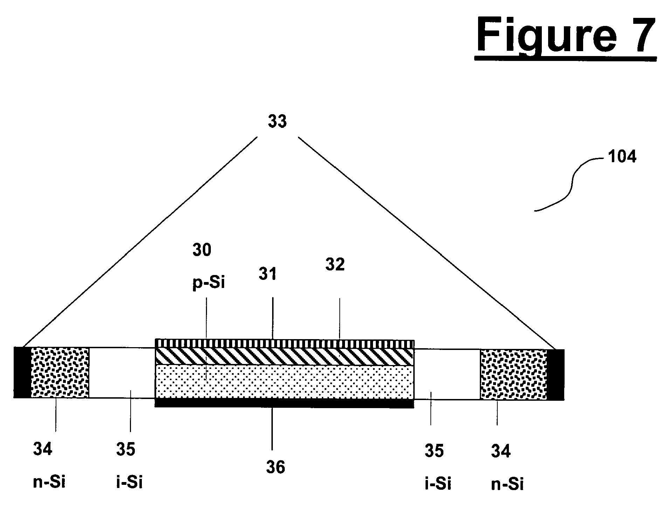

Figure 7 illustrates an alternative cross section of a TFET structure according to embodiments of the present invention, having two channel regions **35** and two drain sections **34,** and whereby the gate (electrode **31** + gate dielectric **32)** only overlaps with the source section **30** and not with the channel region(s) **35.** The structure further comprises a source contact **36** and two drain contacts **33.**

In yet another alternative, the short gate TFET of embodiments of the invention may comprise a tri (triple) gate structure in analogy with multiple gate FET devices (e.g. FinFET devices) whereby the (short) gate is situated at least partly on the top and the sidewalls of the at least one source region extending up to the plane of the interface of the source-channel region and, optionally, on the top and the sidewalls of the channel region, but not on the top and sidewalls of the at least one drain region.

According to a (yet another) embodiment of the invention, the short gate TFET structure may be an all-around gate structure which is especially attractive in vertical devices such as a vertical NW-TFET. Said all-around short gate is situated at least partly around the at least one source region, extending up to the plane of the interface of the source-channel region and optionally around the at least one channel region, but not around the at least one drain region.

The short gate TFET of embodiments of the present invention is further applicable to all TFET implementations independent of the channel doping, including both p-type channel doping, n-type channel doping and intrinsic doping.

The short gate TFET of embodiments of the present invention is further applicable to all TFET implementations independent of the semiconductor material used as source material, as channel material, and as drain material, including a TFET with a source material which is different from the channel material and/or which is different from the drain material, including TFETs with a drain material which is different from the channel material. Possible semiconducting materials are including but not limited to group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof, or carbon nanotubes.

The short gate TFET of embodiments of the present invention is further applicable to all TFET implementations independent of the gate dielectric material and thickness. Possible gate materials are including but not limited to silicon based oxides (e.g. silicon dioxide, silicon oxy nitride), aluminium oxide, high-k oxides (oxides, nitrided oxides, silicates and nitrided silicates of transition metals such as Hf, Ta, Ti, Nb, V, Y, Zr).

According to an embodiment of the invention, the short gate TFET can have an additional gate structure. The uncovered part of the channel (L_{no overlap}) offers the possibility to incorporate a second gate structure. Said second gate structure can be a single or double gate (in similarity to Figure 8A and 8B).

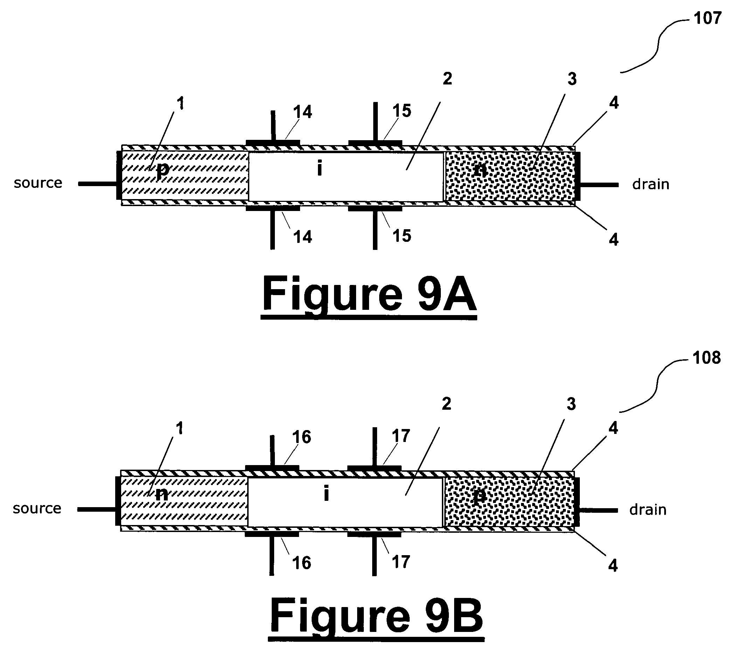

Figure 9A illustrates a cross section of a (double) short gate n-TFET structure having a second (short) gate structure 107 on the remainder of the channel, in accordance with embodiments of the present invention. Said additional (short) gate covers only part of the channel region, and does not cover the drain region. The first gate 14 (covering the source 1 and, optionally, part of the channel) turns on or off the tunnel barrier, the second gate 15 opens or closes the channel as happens in a traditional MOSFET. The gate dielectric underneath both gates can cover the whole length of the short gate TFET structure. The device is off when either the first gate 14 is in the off position or when the second gate 15 is in the off position. The device is on when both gates 14, 15 are in the on position. The logic function implemented by this device is ((gate 1)AND(gate 2)). The electrical equivalent circuit is a TFET in series with a MOSFET. Figure 9B illustrates the complementary structure **108** of Figure 9A whereby the source region 1 is highly n-doped and the drain region **3** is highly p-doped to realize a p-TFET.

According to embodiments of the invention, the short gate TFET comprises a NW. The diameter of the NW, perpendicular to its longitudinal axis, may be in the range of 1nm up to 500 nm, for example between 2 and 200 nm. The length of the NW, along its longitudinal axis may be in the range of 5 nm to 50 µm, for example between 10 nm and 5 µm.

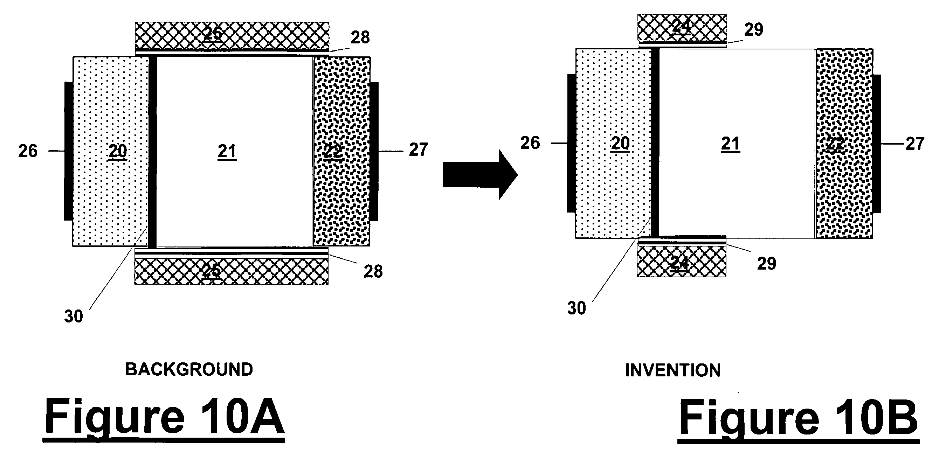

According to an embodiment, the short gate TFET of the present invention may be a NW-TFET which further comprises a heterosection. Figure 10A illustrates a cross-section of a prior art NW-TFET structure having a heterosection **30** and Figure 10B illustrates a cross section of a short gate NW-TFET having a heterosection **30** according to embodiments of the invention. Said heterosection may be made of a semiconductor material (referred to as heterosection material) which is different from the overall semiconductor material, i.e. the source-channel-drain material of the short gate TFET. Said heterosection may be highly doped and may be situated in between the source region (or drain region) and the channel region. Alternatively, said heterosection can be made of a metal such as Al, W, Ta, Ti, Ru, Pd, Rh, Re, Pt, or alloys thereof, a silicide, a germanide, a metal-nitride such as TaN and TiN, a conductive oxide such as RuO₂ and ReO₂, a silicided metal such as CoSi₂, NiSi₂ ,a metal germanide and/or alloys and mixtures thereof. The heterosection (semiconductor) material in the short gate NW-TFET of embodiments of the present invention has defect free interfaces to the overall semiconductor material and may be made of a material that has a lattice constant which is different from the lattice constant of the overall semiconductor material, i.e. the source-channel-drain material of the short gate TFET. Said heterosection semiconductor material may be selected from at least one of group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof. In particular embodiments, the heterosection semiconductor material may be germanium or Siₗ₋ₓGeₓ with x>0.5. The short gate of the short gate NW-TFET is covering at least part of the at least one source region, extending up to the plane of the interface of the source-channel region and, optionally, covering a part or whole of the heterosection and, optionally, part of the at least one channel region, but not covering the drain region. The length of the heterosection may be in the range of 1 nm to 50 nm, for example between 2 nm and 10 nm. The doping level of the heterosection in the short gate TFET of embodiments of the present invention may preferably be in the range of 10¹⁸/cc to 10²¹/cc, for example in the range of 10¹⁹/cc to 5x10²⁰/cc.

The short gate TFET of embodiments of the present invention may further comprise a gate dielectric underneath the gate electrode, said gate dielectric covering at least part of the at least one source region, extending up to the plane of the interface of the source-channel region and, optionally, covering part of the at least one channel region. The gate dielectric covers at least the parts of the source and channel regions also covered by the gate electrode. The gate dielectric may, optionally, also cover part of the channel and drain regions which are not covered by the gate electrode. In particular embodiments, the gate dielectric (e.g. oxide) may be selected from at least one of silicon based oxides (e.g. silicon dioxide, silicon oxy nitride), aluminium oxide, high-k oxides (oxides, nitrided oxides, silicates and nitrided silicates of transition metals such as Hf, Ta, Ti, Nb, V, Y, Zr). In particular embodiments the gate oxide is a high-k oxide such as hafnium oxide. The thickness of the gate dielectric, e.g. gate oxide, may be in the range of 0.5 nm to 20 nm.

In embodiments of the present invention the gate electrode may be made of a conductive material. The conductive material may be selected from at least one of poly silicon, poly germanium, metals such as Al, W, Ta, Ti, Ru, Pd, Rh, Re, Pt, or alloys thereof, metal-nitrides such as TaN and TiN, metal-silicon nitrides such as TaSiN, conductive oxides such as RuO₂ or ReO₃, fully silicided metals (FUSI) such as CoSi₂, NiSi and TiSi₂, fully germanided metals (FUGE). The gate electrode material may be chosen such that a particular gate workfunction is obtained.

In particular embodiments, the at least one source region in the short gate TFET of the present invention may be made of a semiconductor material which is highly p doped (or n doped).

In particular embodiments, the at least one drain region in the short gate TFET of the present invention may be made of a semiconductor material which is highly n doped (or p doped).

The doping level of the source region and drain region in the short gate TFET of some embodiments of the present invention may be in the range of 10¹⁸/cc to 10²¹/cc, for example in the range of 10¹⁹/cc to 5x10²⁰/cc.

In particular embodiments, the at least one channel region in the short gate TFET of the present invention may be made of a semiconductor material which is lowly n doped (or p doped) and which is situated in between the source and drain region.

The doping level of the channel region in the short gate TFET of embodiments of the present invention may be in the range of undoped up to 10¹⁶/cc, for example in the range of undoped up to 5x10¹⁴/cc.

In particular embodiments, the semiconductor material of the source-channel-drain structure in the short gate TFET of the present invention may be selected from at least one of group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof, or carbon nanotubes.

The short gate TFET of some embodiments of the present invention may further comprise an electrical contact on each of the source region and drain region. The electrical contact on each of the source region and drain region may be made from a conductive material which is selected from at least one of a silicide containing structure (NiSi, CoSi₂, TiSi₂, ...), a germanide containing structure, a metal containing structure, poly silicon or a combination thereof. In particular embodiments, said electrical contact on each of the source region and drain region may be a combination of a metal with a silicide.

In a second aspect of the invention, a method is provided for the fabrication of a short gate TFET. Hereinafter, the method according to an embodiment of the invention will be illustrated for a short gate TFET comprising one short (double) gate structure as shown in Figure 4 (cross section). It has to be understood that this is not limiting the invention and that the method may also be applied to create the alternative short gate TFET structures (e.g. comprising a nanowire, a second gate structure,...) as described above.

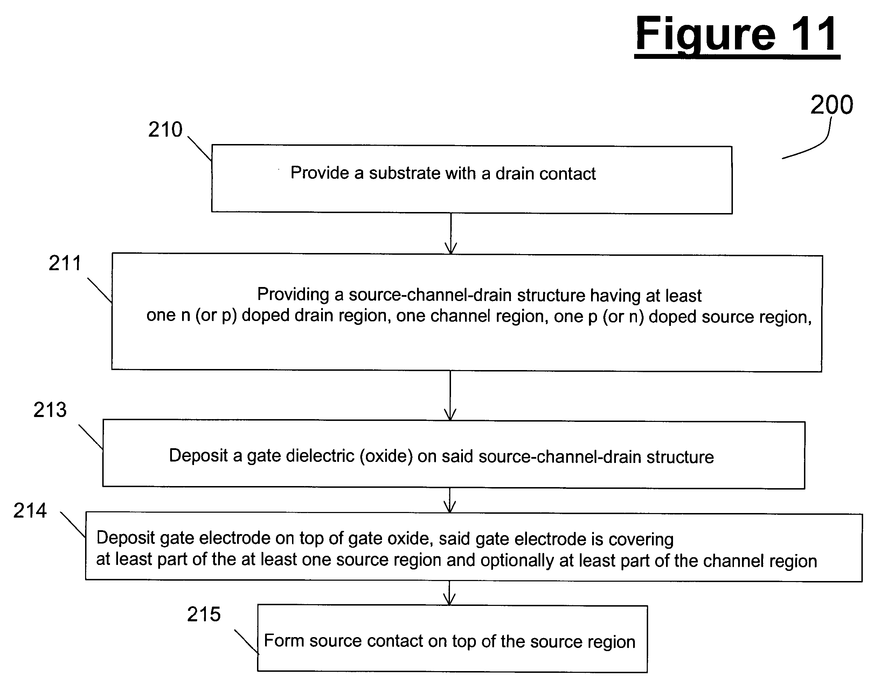

A particular processing method to fabricate a short gate TFET is schematically illustrated in a flowchart **200** shown in Figure 11 and will be described in detail below (with reference to the cross-section in Figure 4). It has, however, to be understood that this is only an example of a suitable method for forming a short gate NW-TFET device according to embodiments of the invention and that the sequence of the process steps as described hereinafter is not limiting the invention.

In a first step **210,** a substrate is provided. Preferably said substrate is a semiconductor substrate such as a silicon substrate or a silicon on insulator (SOI) substrate but any other suitable substrate can be used as well such as, for example, glass, ceramics, etc. According to an embodiment of the invention, in said substrate or alternatively on top of said substrate, a drain contact **27** is created. The drain contact **27,** may be made of a conductive material, e.g. said drain contact **27,** may be a silicide containing structure (NiSi, CoSi₂, TiSi₂...), a germanide containing structure, a metal containing structure, polysilicon or a combination of the above materials. Also disclosed are drain contacts **27,** formed of e.g. conductive oxides and even conductive polymers. In a particular embodiment, the drain contact **27** may be a silicide containing structure.

In a next step **211,** a source-channel-drain structure having at least one n (or p) doped drain region, one channel region, and one p (or n) doped source region is formed. Deposition techniques such as, for example, CVD (Chemical Vapor Deposition), MOCVD (Metal Organic Chemical Vapor Deposition), or PECVD (plasma enhanced chemical vapor deposition) processes can be used. Alternatively etching techniques can be used whereby said structures are etched into the substrate.

The different regions with different doping levels and different doping types need to be created to form the drain region **22,** the channel region **21** and the source region **20** in the source-channel-drain structure. These different regions can be doped during the deposition process to obtain a n-type or p-type region. Alternatively, the doping may be performed after the deposition step by means of an additional doping step. The doping in one specific region, e.g. source region/ drain region is preferably uniform, but may also have a non-uniform doping profile.

A drain region **22** is created. Said drain region **22** may be made of a first semiconductor material which is highly n doped in case of a n-type TFET, or alternatively in case of a p-type TFET said drain region is highly p doped. In embodiments of the present invention, the doping level of the drain region is in the range of 10¹⁸/cc to 10²¹/cc, for example in the range of 10¹⁹/cc to 5.10²⁰/cc.

The channel region of the TFET is formed. In embodiments of the present invention, said channel region may preferably be made of the first semiconductor material, although other suitable/compatible materials can be used. In embodiments of the present invention, the doping level of the channel region may be in the range of undoped up to 10¹⁶/cc doping, for example in the range of undoped up to 10¹⁴/cc doping.

A source region **20** is created next to the channel region. Said source region **20** may be made of the first semiconductor material, although other suitable/compatible materials can be used. The semiconductor material may be highly p doped in case of a n-type TFET (or alternatively in case of a p-type TFET said source region may be highly n doped). The doping level of the source region may be in the range of 10¹⁸/cc to 10²¹/cc, for example in the range of 10¹⁹/cc to 5.10²⁰/cc.

In step **213** a short gate structure is formed onto part of the sidewalls of the source-channel-drain structure, more specifically a single gate, double gate or triple gate structure can be formed depending on the type of TFET (planar, MUGFET, horizontal,..). First a gate dielectric (oxide) **29** is deposited. Said gate dielectric is at least situated below the whole length of the gate electrode but can cover up to the whole length of the TFET structure, i.e. of the underlying source-channel-drain structure. Then, in step **214,** a gate electrode **24** is deposited on top of said gate dielectric **29.** The gate electrode is covering at least part of the source region extending at least up to the interface of the source-channel region and, optionally, part of the channel region such that there is a finite distance between the end of the gate electrode oriented towards the channel and the plane of the channel-drain interface, but such that there is no coverage by the gate electrode of the drain region.

The gate oxide **29** may be selected from at least one of silicon based oxides (e.g. silicon dioxide, silicon oxy nitride), aluminium oxide, high-k oxides (oxides, nitrided oxides, silicates and nitrided silicates of transition metals such as Hf, Ta, Ti, Nb, V, Y, Zr). In particular embodiments said gate oxide is a high-k oxide such as hafnium oxide. The thickness of the gate dielectric, e.g. gate oxide, is preferably in the range of 0.5 nm to 20 nm.

The gate electrode **24** may be made of a conductive material, for example selected from at least one of poly silicon, poly germanium, metals such as Al, W, Ta, Ti, Ru, Pd, Rh, Re, Pt, and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. In particular embodiments said gate electrode is made of a metal of which the workfunction has been engineered specifically for the chosen channel material, the gate dielectric material, gate dielectric thickness and channel doping.

In step **215** an electrical contact is formed on the source region. Said electrical contact may be a conductive material which is selected from at least one of a silicide containing structure (NiSi, CoSi₂, TiSi₂,...), a germanide containing structure, a metal containing structure, poly silicon or a combination thereof. In particular embodiments said electrical contact may be a combination of a metal with a silicide.

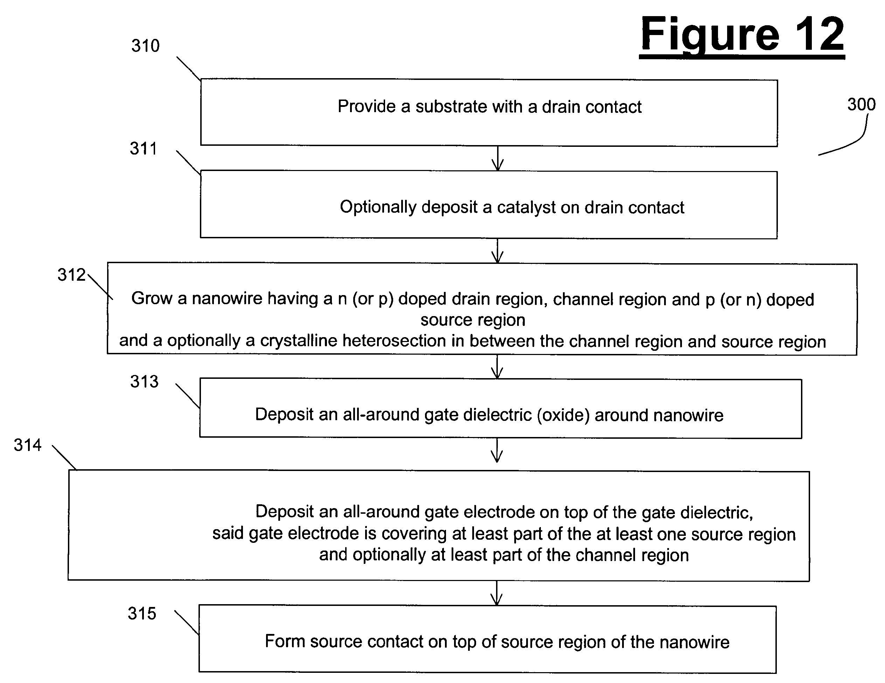

An embodiment of a processing method to fabricate a short gate NW-TFET with optionally having a heterosection is schematically illustrated in a flowchart **300** shown in Figure 12 and will be described in detail below (with reference to the cross-section in Figure 10B). It has, however, to be understood that this is only an example of a suitable method for forming a short gate NW-TFET device according to embodiments of the invention and that the sequence of the process steps as described hereinafter is not limiting the invention.

In step **310,** a substrate is provided. Said substrate may be a semiconductor substrate such as a silicon substrate or a silicon on insulator (SOI) substrate but any other suitable substrate can be used as well such as, for example, glass, ceramics, etc. According to an embodiment of the invention, in said substrate or alternatively on top of said substrate, a drain contact **27** is created. The drain contact **27,** may be made of a conductive material, e.g. said drain contact **27,** may be a silicide containing structure (NiSi, CoSi₂, TiSi₂...), a germanide containing structure, a metal containing structure, polysilicon or a combination thereof. Also disclosed are drain contacts **27,** formed of e.g. conductive oxides and even conductive polymers. In case the drain contact **27** is a metal containing structure, all metals which form an ohmic contact with the material of a nanowire, or in other words all metals having a comparable work function with respect to the work function of the channel material, may be used according to embodiments of the invention. In particular embodiments, the drain contact **27** is a silicide containing structure. The drain contact **27,** can be the starting point for growing the nanowire and can, at the same time, act as the catalyst for the nanowire growth. However, the latter is not essential.

In case the drain contact **27** cannot be used as a catalyst for the subsequent nanowire growth, a catalyst needs to be deposited onto the drain contact in step **311.** Furthermore, the requirement of catalyst particles also depends on the technique used to form the nanowire.

In a next step **312,** a nanowire is grown, e.g. by means of a VLS (Vapor-Liquid-Solid) process, but also any other suitable technique known by a person skilled in the art may be used to form the nanowires according to embodiments of the invention. For example, the nanowire may be grown using techniques such as CVD (Chemical Vapor Deposition), MOCVD (Metal Organic Chemical Vapor Deposition), or PECVD (plasma enhanced chemical vapor deposition) processes. Alternatively, also PLD (Pulsed Laser Deposition), ECD (Electrochemical Deposition), e-beam or MBE (Molecular Beam Epitaxy) processes may be used to grow the nanowires.

During growth of the nanowire, different regions with different doping levels and different doping types are created to form the drain region **22,** the channel region **21,** the source region **20** and (optionally) the heterosection **30** of the nanowire. The different regions in the nanowire can be doped during the growth process to obtain a n-type or p-type region. Alternatively, the doping of the nanowire may be performed after growth of the nanowire by means of an additional doping step. The doping in one specific region, e.g. source region/ drain region is preferably uniform, but may also have a non-uniform doping profile.

During growth of the nanowire, a drain region **22** is created. Said drain region **22** may be made of a first semiconductor material which is highly n doped in case of a n-type NW-TFET, or alternatively in case of a p-type NW-TFET said drain region is highly p doped. The doping level of the drain region may be in the range of 10¹⁸/cc to 10²¹/cc, for example in the range of 10¹⁹/cc to 5.10²⁰/cc.

The channel region of the NW-TFET is formed in the nanowire. Said channel region may be made of the first semiconductor material, although other suitable/compatible materials can be used. The doping level of the channel region may be in the range of undoped up to 10¹⁶/cc, for example in the range of undoped up to 10¹⁴/cc doping.

Optionally, in a step (to create e.g. an n-type NW-TFET), a heterosection 30 may be formed. The heterosection 30 may be made of a second semiconductor material which is such that it has a different lattice constant compared to the lattice constant of the first semiconductor material used to form the channel region **21** of the nanowire. Said second semiconductor material may be highly doped. The second semiconductor material may be selected from at least one of the group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof. In particular embodiments said second semiconductor material is germanium or Siₗ₋ₓGeₓ with x>0.5. The doping level of the heterosection may be in the range of 10¹⁸/cc to 10²¹/cc, for example in the range of 10¹⁹/cc to 5x10²⁰/cc.

Alternatively, said heterosection can be made of metals (Al, W, Ta, Ti, Ru, Pd, Rh, Re, Pt, or alloys thereof), silicides, germanides, metal-nitrides such as TaN and TiN, conductive oxides such as RuO₂ and ReO₂, silicided metals such as CoSi₂, NiSi₂ ,metal germanides or alloys or mixtures thereof.

In a step, a source region **20** is created on top of the channel region (or if a heterosection is present on top of the heterosection). Said source region **20** may be made of a first semiconductor material which is highly p doped in case of a n-type NW-TFET (or alternatively in case of a p-type NW-TFET said source region is highly n doped). The doping level of the source region may be in the range of 10¹⁸/cc to 10²¹/cc, for example in the range of 10¹⁹/cc to 5.10²⁰/cc.

In a step **313,314** a gate structure may be formed onto the sidewalls of the nanowire, more specifically for example an all-around gate structure. First a gate dielectric (e.g. oxide) **29** may be deposited. Said gate dielectric may at least be situated below the whole length of the gate electrode (to be formed later on) but can cover up to the whole length of the NW-TFET structure. Then a gate electrode **24** is deposited on top of said gate dielectric **29.** The gate electrode covers at least part of the source region extending up to the plane of the interface of the source-channel region and, optionally, the heterosection and, also optionally, part of the channel region such that there is a finite distance between the end of the gate electrode oriented towards the channel and the plane of the channel-drain interface, such that there is no coverage by the gate electrode of the drain region.

The gate dielectric **29** may be an oxide, for example selected from at least one of silicon based oxides (e.g. silicon dioxide, silicon oxy nitride), aluminium oxide, high-k oxides (oxides, nitrided oxides, silicates or nitrided silicates of transition metals such as Hf, Ta, Ti, Nb, V, Y, Zr). In particular embodiments said gate oxide may be a high-k oxide such as hafnium oxide. The thickness of the gate dielectric, e.g. gate oxide, may preferably be in the range of 0.5 nm to 20 nm.

The gate electrode **24** may be made of a conductive material, for example selected from at least one of poly silicon, poly germanium, metals such as Al, W, Ta, Ti, Ru, Pd, Rh, Re, Pt, or alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE), workfunction tunable metals, engineered materials to obtain a particular gate workfunction. In particular embodiments, said gate electrode may be made of a metal of which the workfunction has been engineered specifically for the chosen channel material, the gate dielectric material, gate dielectric thickness and channel doping.

In step **315** an electrical contact is formed on the source region (situated on top of the nanowire). Said electrical contact may be made of a conductive material, which for example may be selected from at least one of a silicide containing structure (NiSi, CoSi₂, TiSi₂,...), a germanide containing structure, a metal containing structure, poly silicon or a combination thereof. In particular embodiments, said electrical contact is a combination of a metal with a silicide.

In case the nanowire is not doped during the growth process, an extra doping step may be necessary. For example, implantation of dopant elements followed by activation of the dopant elements by e.g. annealing can be applied to achieve n-type or p-type regions in the nanowire. Alternatively, a layer, which is also referred to as dopant layer and which comprises dopant elements can be deposited or a dopant metal can be selectively deposited, e.g. with electrochemical deposition, onto the nanowire regions (not shown). An anneal step may then be applied so as to incorporate the dopant elements into the nanowire region, resulting in an n-type or p-type region.

The whole processing sequence to obtain a short gate NW-TFET, as shown for example in Figure 12 and as described in the previous steps can be repeated to build a second short gate NW-TFET structure on top of the existing NW-TFET structure starting on the source contact. In case the first NW-TFET structure is an n-type NW-TFET structure, the second structure may for example be a p-type NW-TFET structure.

### EXAMPLES

### Example 1: Simulations performed with device simulator MEDICI to determine the characteristics of an all silicon short gate TFET.

The simulations are performed with device simulator "MEDICI" to determine the characteristics of an all silicon short gate TFET. The short gate TFET structure used for the simulation is shown in Figure 4. The short gate TFET structure is 2-dimensional and has a double-gate. The height of the central part (between the gate dielectrics 29) is 20 nm, and the height of the gate dielectric (hafnium oxide) is 4 nm. The length of the channel region is in one embodiment 100 nm and in another embodiment 1000 nm.

The most important dimensions in the short gate TFET structure to be taken into account for the electrical performance are the length of the short gate L_{gate} = 30nm (short gate) and full gate (full coverage of channel) and the length of the channel region which is in the above embodiments of this example either 100 nm or 1000 nm. The gate-source overlap is in the example 5 nm.

Further parameters of importance are the doping of the source and drain regions. The doping of the source region is in the example p-type doping, the doping level is 10²⁰/cc. The doping of the drain region is in the example n-type doping, the doping level is 10²⁰/cc. The doping of the channel region is not critical, as long as it is lowly doped. The doping level for the channel region used in this simulation example is p-type, 10¹⁵/cc.

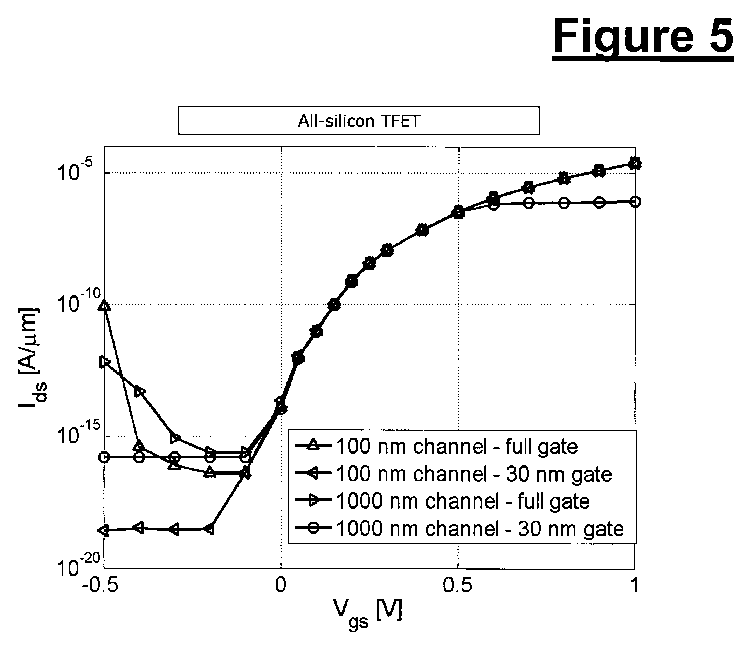

Figure 5 shows simulated output characteristics for the all silicon TFET with a 100nm and 1000nm channel having a full gate or partial gate (gate length = 30nm) after applying a drain voltage, V_{DS} = 1 V. The Figure shows the drain current I_{DS} as a function of gate voltage V_{GS} (varied from -0.5V up to 1V).

The off-currents are very low. The onset of ambipolar behaviour can however already be observed for the configurations with the full gate. The on-currents are identical for the two configurations with the 100 nm channel, which means that there is no performance degradation by having a shorter gate. The on-current for the 1000 nm channel is smaller for the short-gate configuration, and illustrates that if the gate becomes too short compared to the total channel length, it can affect the on-current and therefore the performance of the TFET.

### Example 2: Simulations performed with device simulator MEDICI to determine the characteristics of an all germanium short gate TFET.

The simulations are performed with device simulator "MEDICI" to determine the characteristics of an all germanium short gate TFET. The short gate TFET structure used for the simulation is shown in Figure 4. The short gate TFET structure is 2-dimensional and has a double-gate. The height of the central part (between the gate dielectrics 29) is 20 nm, and the height of the gate dielectric (hafnium oxide) is 4 nm. The length of the channel region is 100 nm, and the length of the short gate is 95 nm (= 5 nm overlap with the source, 10 nm gap between gate and drain electrode) versus a full gate (100 nm + 2 x 5 nm (for gate/source and gate/drain overlap) or full coverage).

The most important dimensions in the short gate TFET structure to be taken into account for the electrical performance are the length of the short gate L_{gate} = 95 nm (short gate) and full gate L_{gate} = 110 nm (full coverage of channel) and the length of the channel region.

Further parameters of importance are the doping of the source and drain regions. The doping of the source region is in the example p-type doping, the doping level is 10²⁰/cc. The doping of the drain region is in the example n-type doping, the doping level is 10²⁰/cc. The doping of the channel region is not critical, as long as it is lowly doped. The doping level for the channel region used in this simulation example is n-type, 10¹³/cc. The doping of the channel region is not critical, as long as it is lowly doped.

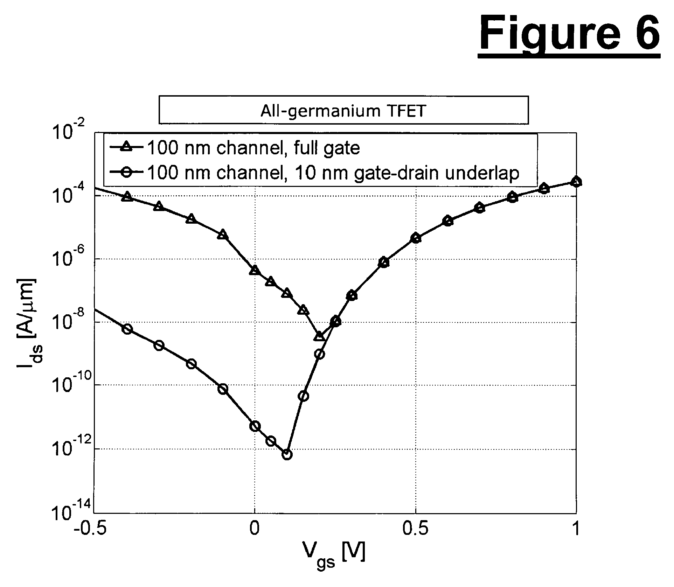

Figure 6 shows simulated output characteristics for the all germanium TFET with a 100 nm channel having a full gate or partial gate (gate length = 95 nm) after applying a drain voltage, V_{DS} = 1 V. The Figure shows the drain current I_{DS} as a function of gate voltage V_{GS} (varied from -0.5V up to 1V).

The off-current is 4 orders of magnitude smaller for the configuration with the shorter gate, than the configuration with the full gate. The short gate TFET therefore reduces the ambipolar behaviour significantly. The on-currents are identical for the two configurations, which means that there is no performance degradation by having a shorter gate.

## Claims

1. A nanowire Tunnel Field Effect Transistor (101) comprising:
- A source-channel-drain nanowire structure comprising at least one doped source region (1, 20, 30), at least one doped drain region of a conductivity type opposite to that of the source (3, 22, 34), and a channel region (2, 21, 35) which is situated in between the at least one source region and the at least one drain region, and forming a source-channel interface with the source region and a drain-channel interface with the drain region,
- a gate electrode (6, 24, 31) which is covering at least part of the at least one source region and only part of the channel, such that there is a finite distance between the end of the gate electrode and the plane of the channel-drain interface, such that there is no coverage by the gate electrode of the drain region,
whereby said channel region is made of a semiconductor material which is doped with a doping level in the range of undoped up to 10¹⁶/cc.

2. A Tunnel Field Effect Transistor according to claim 1, further comprising a gate dielectric (4, 29, 32) covering at least part of one source region of the source-channel-drain structure along the longitudinal direction thereof, the gate dielectric being present between the source-channel-drain structure and the gate electrode, the gate electrode not extending beyond said gate dielectric.

3. The Tunnel Field Effect Transistor according to any of the previous claims wherein said source-channel-drain structure is a horizontal structure and said gate electrode is a double gate structure situated on the sidewalls of said horizontal source-channel-drain structure.

4. The Tunnel Field Effect Transistor according to any of the previous claims wherein said source-channel-drain structure is a horizontal structure and said TFET is a triple-gate FET and said gate electrode is a triple gate structure situated on the sidewalls and on top of the source-channel-drain structure of the triple-gate FET.

5. The Tunnel Field Effect Transistor according to any of the previous claims wherein said source-channel-drain structure is a horizontal or a vertical structure and said gate electrode is an all-around gate structure around said horizontal or vertical source-channel-drain structure.

6. The Tunnel Field Effect Transistor according to any of the previous claims wherein said gate electrode is an all-around gate structure.

7. The Tunnel Field Effect Transistor according to any of the previous claims wherein said Tunnel Field Effect Transistor is a nanowire -TFET comprising a heterosection (30) in the source-channel-drain structure and whereby said heterosection is made of a semiconductor material which is different to the overall semiconductor material of the source-channel-drain structure of the TFET.

8. The Tunnel Field Effect Transistor according to claim 7 wherein the length of said heterosection (30) is in the range of 1 nm and 50 nm.

9. The Tunnel Field Effect Transistor according to any of claims 7 or 8, wherein the doping level of the heterosection (30) is in the range of 10¹⁸/cc to 10²¹/cc.

10. The Tunnel Field Effect Transistor according to any of the previous claims, further comprising a second short gate structure (15, 17) on the remainder of the channel region.

11. The Tunnel Field Effect Transistor according to any of the previous claims whereby said at least one source region is made of a semiconductor material which is doped with a first dopant, said at least one drain region is made of a semiconductor material which is doped with a second dopant and whereby said doping level of the source region and drain region are in the range of 10¹⁸/cc to 10²¹/cc.

12. The Tunnel Field Effect Transistor according to any of the previous claims whereby the length of the channel region (L_{channel}) in the TFET is in the range of 5 nm to 50 µm.

13. The Tunnel Field Effect Transistor according to any of the previous claims whereby the length of the gate electrode (L_{gate}) is between 1 nm and 50 µm.

14. The Tunnel Field Effect Transistor according to any of the previous claims whereby the length of the channel region which is not covered by a gate electrode (L_{no overlap}) is in the range of 1 nm up to the whole length of the channel region.

15. A method for fabricating a nanowire Tunnel Field Effect Transistor (101), said method comprising the steps of:
- growing on a substrate a source-channel-drain nanowire structure made of a semiconductor material, said structure having at least one drain region (3, 22, 34), a channel region (2, 21, 35), and at least one source region (1, 20, 30), there being a source-channel interface and a drain-channel interface,
- selectively doping said at least one drain region, said channel region, and at least one source region to a desired doping level and dopant type,
the drain being of a condctivity type opposite to that of the source,
- providing on the source-channel-drain structure a gate electrode (6, 24, 31) whereby said gate electrode covers at least part of the at least one source region and only part of the channel, such that there is a finite distance between the end of the gate electrode oriented towards the channel and the plane of the channel-drain interface, such that there is no coverage by the gate electrode of the drain region, whereby said channel region is made of a semiconductor material which is doped with a doping level in the range of undoped up to 10¹⁶/cc.

16. A method according to claim 15, further comprising providing source and drain contacts (26, 27; 36, 33).

17. The method according to any of claims 15 or 16, further comprising providing a heterosection (30) in the source-channel-drain structure, the heterosection being made of a semiconductor material which is different to the overall semiconductor material of the source-channel-drain structure of the Tunnel Field Effect Transistor.

18. Use of the method of any of claims 15 to 17 for forming a Tunnel Field Effect 14 Transistor according to any of claims 1 to 14.

## Patentansprüche

1. Nanodraht-Tunnel-Feldeffekttransistor (101), umfassend:
- eine Source-Kanal-Drain-Nanodrahtstruktur, die zumindest ein dotiertes Source-Gebiet (1, 20, 30), zumindest ein dotiertes Drain-Gebiet (3, 22, 34) mit einem Leitfähigkeitstyp, der jenem der Source entgegengesetzt ist, und ein Kanalgebiet (2, 21, 35), das sich zwischen dem zumindest einen Source-Gebiet und dem zumindest einen Drain-Gebiet befindet und eine Source-Kanal-Schnittstelle mit der Source-Gebiet und eine Drain-Kanal-Schnittstelle mit der Drain-Gebiet bildet, umfasst
- eine Gate-Elektrode (6, 24, 31), die zumindest einen Teil des zumindest einen Source-Gebiets und nur einen Teil des Kanals bedeckt, so dass ein endlicher Abstand zwischen dem Ende der Gate-Elektrode und der Ebene der Kanal-Drain-Schnittstelle vorhanden ist, so dass keine Abdeckung des Drain-Gebiets durch die Gate-Elektrode vorhanden ist,
wobei das Kanalgebiet aus einem Halbleitermaterial besteht, das mit einem Dotierungswert im Bereich von undotiert bis 10¹⁶/cc dotiert ist.

2. Tunnel-Feldeffekttransistor nach Anspruch 1, des Weiteren umfassend ein Gate-Dielektrikum (4, 29, 32), das zumindest einen Teil eines Source-Gebiets der Source-Kanal-Drain-Struktur entlang deren Längsrichtung bedeckt, wobei das Gate-Dielektrikum zwischen der Source-Kanal-Drain-Struktur und der Gate-Elektrode vorhanden ist, wobei sich die Gate-Elektrode nicht über das Gate-Dielektrikum hinaus erstreckt.

3. Tunnel-Feldeffekttransistor nach einem der vorangehenden Ansprüche, wobei die Source-Kanal-Drain-Struktur eine horizontale Struktur ist und die Gate-Elektrode eine doppelte Gate-Struktur ist, die sich an den Seitenwänden der horizontalen Source-Kanal-Drain-Struktur befindet.

4. Tunnel-Feldeffekttransistor nach einem der vorangehenden Ansprüche, wobei die Source-Kanal-Drain-Struktur eine horizontale Struktur ist und der TFET ein Dreifach-Gate-FET ist und die Gate-Elektrode eine Dreifach-Gate-Struktur ist, die sich an den Seitenwänden und an einer Oberseite der Source-Kanal-Drain-Struktur des Dreifach-Gate-FET befindet.

5. Tunnel-Feldeffekttransistor nach einem der vorangehenden Ansprüche, wobei die Source-Kanal-Drain-Struktur eine horizontale oder eine vertikale Struktur ist und die Gate-Elektrode eine ringsum verlaufende Gate-Struktur um die horizontale oder vertikale Source-Kanal-Drain-Struktur ist.

6. Tunnel-Feldeffekttransistor nach einem der vorangehenden Ansprüche, wobei die Gate-Elektrode eine ringsum verlaufende Gate-Struktur ist.

7. Tunnel-Feldeffekttransistor nach einem der vorangehenden Ansprüche, wobei der Tunnel-Feldeffekttransistor ein Nanodraht-TFET ist, der einen Heteroabschnitt (30) in der Source-Kanal-Drain-Struktur umfasst und wobei der Heteroabschnitt (30) aus einem Halbleitermaterial besteht, das sich von dem gesamten Halbleitermaterial der Source-Kanal-Drain-Struktur des TFET unterscheidet.

8. Tunnel-Feldeffekttransistor nach Anspruch 7, wobei die Länge des Heteroabschnitts (30) im Bereich von 1 nm und 50 nm liegt.

9. Tunnel-Feldeffekttransistor nach einem der Ansprüche 7 oder 8, wobei der Dotierungswert des Heteroabschnitts (30) im Bereich von 10¹⁸/cc bis 10²¹/cc liegt.

10. Tunnel-Feldeffekttransistor nach einem der vorangehenden Ansprüche, des Weiteren umfassend eine zweite kurze Gate-Struktur (15, 17) auf dem Rest des Kanalgebiets.

11. Tunnel-Feldeffekttransistor nach einem der vorangehenden Ansprüche, wobei das zumindest eine Source-Gebiet aus einem Halbleitermaterial besteht, das mit einem ersten Dotierungsmittel dotiert ist, wobei das zumindest eine Drain-Gebiet aus einem Halbleitermaterial besteht, das mit einem zweiten Dotierungsmittel dotiert ist, und wobei der Dotierungswert des Source-Gebiets und Drain-Gebiets im Bereich von 10¹⁸/cc bis 10²¹/cc liegt.

12. Tunnel-Feldeffekttransistor nach einem der vorangehenden Ansprüche, wobei die Länge des Kanalgebiets (L_{channel}) im TFET im Bereich von 5 nm bis 50 µm liegt.

13. Tunnel-Feldeffekttransistor nach einem der vorangehenden Ansprüche, wobei die Länge der Gate-Elektrode (L_{gate}) zwischen 1 nm und 50µm beträgt.

14. Tunnel-Feldeffekttransistor nach einem der vorangehenden Ansprüche, wobei die Länge des Kanalgebiets, die nicht von einer Gate-Elektrode bedeckt ist (L_{no overlap}), im Bereich von 1 nm bis zur gesamten Länge des Kanalgebiets liegt.

15. Verfahren zur Herstellung eines Nanodraht-Tunnel-Feldeffekttransistors (101), wobei das Verfahren die folgenden Schritte umfasst:
- Züchten auf einer Trägerschicht einer Source-Kanal-Drain-Nanodrahtstruktur, die aus einem Halbleitermaterial besteht, wobei die Struktur zumindest ein Drain-Gebiet (3, 22, 34), ein Kanalgebiet (2, 21, 35) und zumindest ein Source-Gebiet (1, 20, 30) aufweist, wobei eine Source-Kanal-Schnittstelle und eine Drain-Kanal-Schnittstelle vorhanden sind,
- selektives Dotieren des zumindest einen Drain-Gebiets, des Kanalgebiet und des zumindest einen Source-Gebiets auf einen gewünschten Dotierungswert und Dotierungstyp,
wobei der Drain einen Leitfähigkeitstyp hat, der jenem der Source entgegengesetzt ist,
- Bereitstellen auf der Source-Kanal-Drain-Struktur einer Gate-Elektrode (6, 24, 31), wobei die Gate-Elektrode zumindest einen Teil des zumindest einen Source-Gebiets und nur einen Teil des Kanals bedeckt, so dass ein endlicher Abstand zwischen dem Ende der Gate-Elektrode, das zum Kanal ausgerichtet ist, und der Ebene der Kanal-Drain-Schnittstelle vorhanden ist, so dass keine Abdeckung des Drain-Gebiets durch die Gate-Elektrode vorhanden ist, wobei das Kanalgebiet aus einem Halbleitermaterial besteht, das mit einem Dotierungswert im Bereich von undotiert bis 10¹⁶/cc dotiert ist.

16. Verfahren nach Anspruch 15, des Weiteren umfassend ein Bereitstellen von Source- und Drain-Kontakten (26, 27; 36, 33).

17. Verfahren nach einem der Ansprüche 15 oder 16, des Weiteren umfassend ein Bereitstellen eines Heteroabschnitts (30) in der Source-Kanal-Drain-Struktur, wobei der Heteroabschnitt aus einem Halbleitermaterial besteht, das sich vom gesamten Halbleitermaterial der Source-Kanal-Drain-Struktur des Tunnel-Feldeffekttransistors unterscheidet.

18. Verwendung des Verfahrens nach einem der Ansprüche 15 bis 17 zur Bildung eines Tunnel-Feldeffekttransistors nach einem der Ansprüche 1 bis 14.

## Revendications

1. Transistor à Effet de Champ à effet Tunnel à nanofil (101) comprenant :
- une structure de nanofil source-canal-drain comprenant au moins une région de source dopée (1, 20, 30), au moins une région de drain dopée d'un type de conductibilité opposé à celui de la source (3, 22, 34) et une région de canal (2, 21, 35) qui est située entre l'au moins une région de source et l'au moins une région de drain, et formant une interface source-canal avec la région de source et une interface drain-canal avec la région de drain,
- une électrode de grille (6, 24, 31) qui couvre au moins une partie de l'au moins une région de source et seulement une partie du canal, de sorte qu'il y a une distance finie entre l'extrémité de l'électrode de grille et le plan de l'interface canal-drain, de sorte qu'il n'y a aucune couverture par l'électrode de grille de la région de drain,
de sorte que ladite région de canal est faite d'une matière semi-conductrice qui est dopée avec un niveau de dopage dans la plage de non dopé jusqu'à 10¹⁶/cm³.

2. Transistor à Effet de Champ à effet Tunnel selon la revendication 1, comprenant en outre un diélectrique de grille (4, 29, 32) couvrant au moins une partie d'une région de source de la structure source-canal-drain le long de sa direction longitudinale, le diélectrique de grille étant présent entre la structure source-canal-drain et l'électrode de grille, l'électrode de grille ne s'étendant pas au-delà dudit diélectrique de grille.

3. Transistor à Effet de Champ à effet Tunnel selon n'importe laquelle des revendications précédentes, dans lequel
ladite structure source-canal-drain est une structure horizontale et ladite électrode de grille est une structure à grille double située sur les parois latérales de ladite structure source-canal-drain horizontale.

4. Transistor à Effet de Champ à effet Tunnel selon n'importe laquelle des revendications précédentes, dans lequel
ladite structure source-canal-drain est une structure horizontale et ledit TFET est un FET à grille triple et ladite électrode de grille est une structure à grille triple située sur les parois latérales et sur le dessus de la structure source-canal-drain du FET à grille triple.

5. Transistor à Effet de Champ à effet Tunnel selon n'importe laquelle des revendications précédentes, dans lequel
ladite structure source-canal-drain est une structure horizontale ou verticale et ladite électrode de grille est une structure de grille tout-autour autour de ladite structure source-canal-drain horizontale ou verticale.

6. Transistor à Effet de Champ à effet Tunnel selon n'importe laquelle des revendications précédentes, dans lequel ladite électrode de grille est une structure de grille tout-autour.

7. Transistor à Effet de Champ à effet Tunnel selon n'importe laquelle des revendications précédentes, dans lequel
ledit Transistor à Effet de Champ à effet Tunnel est un TFET à nanofil comprenant une section hétérogène (30) dans la structure source-canal-drain et de sorte que ladite section hétérogène est faite d'une matière semi-conductrice qui est différente de la matière semi-conductrice globale de la structure source-canal-drain du TFET.

8. Transistor à Effet de Champ à effet Tunnel selon la revendication 7, dans lequel la longueur de ladite section hétérogène (30) est dans la plage de 1 nm à 50 nm.

9. Transistor à Effet de Champ à effet Tunnel selon n'importe laquelle des revendications 7 ou 8, dans lequel le niveau de dopage de la section hétérogène (30) est dans la plage de 10¹⁸/cm³ à 10²¹/cm³.

10. Transistor à Effet de Champ à effet Tunnel selon n'importe laquelle des revendications précédentes, comprenant en outre une seconde structure de grille courte (15, 17) sur le reste de la région de canal.

11. Transistor à Effet de Champ à effet Tunnel selon n'importe laquelle des revendications précédentes de sorte que ladite au moins une région de source est faite d'une matière semi-conductrice qui est dopée avec une première impureté, ladite au moins une région de drain est faite d'une matière semi-conductrice qui est dopée avec une seconde impureté et de sorte que ledit niveau de dopage de la région de source et de la région de drain est dans la plage de 10¹⁸/cm³ à 10²¹/cm³.

12. Transistor à Effet de Champ à effet Tunnel selon n'importe laquelle des revendications précédentes, de sorte que la longueur de la région de canal (L_{channel}) dans le TFET est dans la plage de 5 nm à 50 µm.

13. Transistor à Effet de Champ à effet Tunnel selon n'importe laquelle des revendications précédentes, de sorte que la longueur de l'électrode de grille (L_{gate}) est entre 1 nm et 50 µm.

14. Transistor à Effet de Champ à effet Tunnel selon n'importe laquelle des revendications précédentes, de sorte que la longueur de la région de canal qui n'est pas couverte par une électrode de grille (L_{no overlap}) est dans la plage de 1 nm jusqu'à la longueur totale de la région de canal.

15. Procédé de fabrication d'un Transistor à Effet de Champ à effet Tunnel à nanofil (101), ledit procédé comprenant les étapes de :
- croissance sur un substrat d'une structure source-canal-drain à nanofil faite d'une matière semi-conductrice, ladite structure ayant au moins une région de drain (3, 22, 34), une région de canal (2, 21, 35) et au moins une région de source (1, 20, 30), une interface source-canal et une interface drain-canal existant,
- dopage sélectif de ladite au moins une région de drain, ladite région de canal et au moins une région de source à un niveau de dopage et type d'impureté souhaités,
le drain étant d'un type de conductivité opposé à celui de la source,
- fourniture sur la structure source-canal-drain d'une électrode de grille (6, 24, 31) de sorte que ladite électrode de grille couvre au moins une partie de l'au moins une région de source et seulement une partie du canal, de sorte qu'il y a une distance finie entre l'extrémité de l'électrode de grille orientée vers le canal et le plan de l'interface canal-drain, de sorte qu'il n'y a aucune couverture par l'électrode de grille de la région de drain, de sorte que ladite région de canal est faite d'une matière semi-conductrice qui est dopée avec un niveau de dopage dans la plage de non dopé jusqu'à 10¹⁶/cm³.

16. Procédé selon la revendication 15, comprenant en outre la fourniture de contacts de source et de drain (26, 27 ; 36, 33).

17. Procédé selon n'importe laquelle des revendications 15 ou 16, comprenant en outre la fourniture d'une section hétérogène (30) dans la structure source-canal-drain, la section hétérogène étant faite d'une matière semi-conductrice qui est différente de la matière semi-conductrice globale de la structure source-canal-drain du Transistor à Effet de Champ à effet Tunnel.

18. Utilisation du procédé selon n'importe laquelle des revendications 15 à 17 pour former un Transistor à Effet de Champ à effet Tunnel selon n'importe laquelle des revendications 1 à 14.
